# EUROPÄISCHE PATENTSCHRIFT

(11) **EP 1 224 698 B1**
(45) Veröffentlichungstag und Bekanntmachung des Hinweises auf die Patenterteilung: **29.03.2006**
(21) Anmeldenummer: 00967738.6
(22) Anmeldetag: 21.09.2000
(51) Int. Cl.: H01L 25/16, H01L 31/0232, H01L 31/0203

(54) **VERFAHREN ZUM HERSTELLEN EINER MIKROFUNKTIONALEN VERBUNDVORRICHTUNG**
METHOD FOR PRODUCING A MICROFUNCTIONAL COMPOSITE DEVICE
PROCEDE DE PRODUCTION D'UN DISPOSITIF D'INTERCONNEXION MICROFONCTIONNEL

(30) Priorität: 22.09.1999 DE 19945470
(43) Veröffentlichungstag der Anmeldung: 24.07.2002
(73) Patentinhaber: Fraunhofer-Gesellschaft zur Förderung der angewandten Forschung e.V., 80686 München (DE)
(72) Erfinder: BUSS, Wolfgang, 07747 Jena (DE); MOHAUPT, Matthias, 07778 Altengönna (DE)
(74) Vertreter: Grünecker, Kinkeldey, Stockmair & Schwanhäusser Anwaltssozietät
(86) Internationale Anmeldenummer: PCT/EP2000/009262
(87) Internationale Veröffentlichungsnummer: WO 2001/022492

(56) Entgegenhaltungen:
- US-A- 5 071 792
- US-A- 5 500 540
- US-A- 5 668 033
- US-A- 5 858 814

## Beschreibung

Die vorliegende Erfindung betrifft ein Verfahren zur Herstellung einer mikrofunktionalen Verbundvorrichtung mit zueinander justiert angebrachten mikrofunktionalen Elementen, wobei ein erster Teil der mikrofunktionalen Komponenten auf einem ersten Trägersubstrat geschaffen wird, ein zweiter Teil der mikrofunktionalen Komponenten auf einem zweiten Trägersubstrat geschaffen wird, das erste und zweite Trägersubstrat zueinander justiert werden und die zueinander justierten ersten und zweiten Trägersubstrate miteinander zur Bildung der mikrofunktionalen Verbundvorrichtung verbunden werden.

Mikrofunktionale Elemente bezeichnen dabei sowohl elektronische, optoelektronische, optische, mikromechanische Komponenten wie etwa auf einem Halbleitersubstrat bzw. auf einem optischen Substrat aufgebrachte elektronische Schaltungen, lichtempfindliche Bereiche zusammen mit einer geeigneten Auswerteelektronik (z.B. CCD-Arrays), Farbfilter für CCD-Arrays, als auch beliebige andere sensorische Komponenten, die vorteilhafterweise auf Substraten unabhängig zu entsprechenden Mikroelektronikkomponenten gefertigt werden.

Insbesondere auf dem Gebiet der Optosensorik besteht die Notwendigkeit, optoelektronische Bauelemente, die auf einem Halbleiterwafer integriert sind, mit optischen Komponenten zu versehen. Bei der Verwendung optosensorischer Bauelemente werden optische Signale selektiv bezüglich ihrer Wellenlänge, Polarisation oder Einstrahlwinkel erfasst. Die Umsetzung dieser optischen Eigenschaften der Bauelemente wird beispielsweise bei Halbleiterfotosensoren durch eine hybride oder monolithische Integration mikrooptischer Elemente verwirklicht. So werden beispielsweise auf den fotoempfindlichen Flächen des Halbleiters Dünnschichtsysteme zur Absorption oder Reflexion der unerwünschten Strahlungsanteile verwendet. Weiterhin können direkt aufgesetzte optische Komponenten, wie beispielsweise Einzellinsen und Linsenarrays, Prismen oder Gitterstrukturen, zur Erreichung des gewünschten optischen Verhaltens auf dem Halbleiter aufgebracht werden. Die technische Umsetzung der Integration mikrooptischer Funktionsgruppen in und auf den fotosensitiven Bereichen optoelektronischer Bauelemente auf einem Halbleiterwafer ist allerdings in effizienter Weise lediglich durch eine weitestgehende Anlehnung an die Prozessschritte der modernen Mikroelektronik- und Mikrosystemfertigung möglich.

Es sind eine Vielzahl unterschiedlicher Technologien bekannt, um mikrooptische Funktionselemente mit fotoempfindlichen Bereichen auf Halbleitersubstraten zu kombinieren. So ist aus der DE 196 08 667 und aus der DE 196 48 844 bekannt, Fotoempfängermatrizen mit einer Polymerablagerung zu beschichten und darin durch Heißprägen diffraktive optische Elemente herzustellen.

Aus "Dielectric Micro-Filters for Locally Resolving Color Sensors", M. Frank, 1998, Laser und Optoelektronik Vol. 30(2) 1998, ist auch bekannt, dielektrische Filterschichtsysteme im wesentlichen ganzflächig auf einem Wafer durch strukturierte Abscheidung zu erzeugen. Beim Aufbau solcher Hybridbauelemente werden zunächst optische Elemente, wie Mikrolinsen oder Farbfilterstrukturen, in oder auf Glassubstraten erzeugt und anschließend werden durch justiertes Klebefügen der vereinzelten Glassubstratchips mit den integrierten Mikrooptiken diese auf die Fotoempfängerstrukturen eines Halbleitenwafers aufgebracht.

Aus Mechatronic-Entwicklungen sind Verfahren bekannt, in denen prozessierte Siliziumwafer mit Glaswafem ganzflächig verbunden werden. Der Glaswafer dient dabei als mechanisches Stützsubstrat des während der Verarbeitung stark gedünnten und strukturierten Siliziumwafers. Glas-Silizium-Waferverbünde in dieser Art werden ebenfalls für "Chip-Scale-Packaging"-Aufbauten von Speicher- und Prozessorbauelementen für Smart Cards verwendet. Die Verbindung des Silizium- und des Glaswafers erfolgt dabei durch Kleben oder anodisches Bonden.

Obwohl die strukturierte Direktbeschichtung der fotosensitiven Flächen auf einem Halbleiterwafer mittels sogenannter Kaltbeschichtungstechnologien sowie das punktuelle Abformen von Linsen und Mikroprismen mittels UV-Reaktionsguß für den Halbleiterwafer verträgliche Verfahren sind und lediglich die Justierung des Wafers zu einer Maske erfordem, belassen diese Verfahren den optosensorischen Verbundwafer im Chip-Stadium und erfordern nachfolgend den kompletten Zyklus der herkömmlichen elektrischen Kontaktierung und Häusung der Optosensoren.

Das gestapelte Fügen von Glas- und Siliziumwafem, wie dies beispielsweise in den US-Patentschriften US 5 413 955 und US 5 915 168 beschrieben ist, erlaubt zwar das Herstellen eines Verbundwafers, worin ein Fotoempfängerwafer von zwei Glaswafem eingeschlossen ist, wobei allerdings einer der Glaswafer mit regelmäßigen Öffnungen versehen sein muss, um die Kontaktanschlüsse der Fotoempfänger frei zu halten. Die einzige effektive Strukturierungstechnologie für Glaswafer, das maskierte nasschemische Ätzen mittels Flusssäure, ist jedoch mit vielen Verfahren zur Erzeugung mikrooptischer Komponenten auf dem Glaswafer, wie beispielsweise der Filterabscheidung auf dem Wafer oder dem Ionenaustausch zur Erzeugung von GRIN-Linsen, nicht verträglich.

Die US-Patentschrift US 5 500 540 beschreibt ein Verfahren, in dem optische Elemente, wie Mikrolinsen, ganzflächig auf einem Optoelektronikwafer erzeugt und die elektrischen Anschlusskontakte nachträglich freigelegt werden. Die optischen Elemente lassen sich dabei allerdings nur auf optisch transparenten Medien, wie beispielsweise Fotolack, Polyimid und gewissen SiO₂-Schichten, herstellen.

Weiterhin ist beispielsweise aus "Shell-BGA A Thin Chip Size Integrated Circuit Package" von G. Zilber, 1996, Proceedings of International Conference on Chip Scale Packaging (CHIPCON'96), Sunnyvale, Califomien, bekannt, einen Glaswafer auf einen prozessierten Siliziumwafer zu montieren und nachfolgend den Siliziumwafer im mechanisch stabilen Verbund rückseitig zu dünnen. Dabei werden durch spezielle Ätztechniken die elektrischen Kontakte der Siliziumschaltung von hinten geöffnet, so dass nach dem Fügen eines weiteren Glaswafers und dessen Strukturierung ein Herausführen der elektrischen Kontakte auf die Außenfläche dieses zuletzt gefügten Glaswafers möglich ist. Dieses Verfahren erfordert insbesondere bei den verwendeten Ätzschritten einen sehr hohen Aufwand.

Aus JP 09-321317 ist ein Verfahren zur Herstellung mikrofunktionaler Verbundvorrichtungen bekannt, das einen ersten Wafer durch Trenngräben in Füge- und Freizonen unterteilt. Eine Verbindung zweier Wafer erfolgt nur in den Fügezonen und die Freizonen sind mechanisch herauslösbar.

Es ist die Aufgabe der vorliegenden Erfindung, ein vereinfachtes Verfahren zum justierten Verbinden zweier oder mehrerer Trägersubstrate, die mit mikrofunktionalen Elementen versehen sind, ohne die oben erwähnten Einschränkungen bereitzustellen.

Diese Aufgabe wird durch ein Verfahren der eingangs erwähnten Art gelöst, indem das erste Trägersubstrat in Fügezonen und Freizonen durch Bildung von Trenngräben im ersten Trägersubstrat unterteilt wird, und die Verbindung des ersten und zweiten Trägersubstrats derart stattfindet, dass in den Fügezonen eine feste Verbindung der beiden Trägersubstrate erfolgt und die Freizonen des ersten Trägersubstrats aus der Verbundvorrichtung herauslösbar sind, weil auf die Freizonen und die Trenngräben, von dem Verbinden, auf einem des beiden Substrate, ein Trennmittel abgeschieden wurde. Das Trennmittel unterbindet die Wirkung des Haftmittels. Dieses Verfahrensschrit gewährleistet, dass keine mechanische Kopplung zwischen eines Freizone und dem zweiten Trägersubstrat such dem Zusammenfügen entsteht. Durch das Unterteilen eines Trägersubstrats in Fügezonen, die funktionale mikrotechnische Komponenten beinhalten, und in Freizonen mittels eines Trenngrabens, gelingt es in der vorliegenden Erfindung, die Fügezonen mit einem entsprechenden Bereich auf dem zweiten Trägersubstrat, das funktionale Komponenten, die beispielsweise komplementär zu den Funktionsgruppen auf den Fügezonen sein können, aufweist, auf Substratebene, d.h. ganzflächig, mechanisch zu fixieren, wobei die Bildung der mikrofunktionalen Elemente auf jeweils dem ersten und zweiten Trägersubstrat zu herkömmlichen Verfahrensschritten kompatibel bleibt, d.h., die erfindungsgemäße Herstellung der Verbundvorrichtung erfordert keine Änderungen im Herstellungsprozess der mikrofunktionalen Komponenten aufgrund der beabsichtigten anschließenden Verbindung der jeweiligen Trägersubstrate. Ferner ist durch die teilstrukturierten, aber ebenen Außenflächen des entstehenden Substratverbunds ein weiterer Aufbau zusätzlicher Substratebenen möglich.

Vorteilhafterweise werden die Trenngräben des ersten Trägersubstrats vollständig geöffnet, wobei das erste Trägersubstrat durchtrennt wird.

In weiterer vorteilhafter Ausgestaltung wird die feste Verbindung durch ein Haftmittel gebildet wird. Auf diese Weise kann eine mechanisch sehr stabile Verbindung, die beispielsweise die durch Adhäsion bewirkte Festigkeit übeqrifft, erreicht werden.

Vorteilhafterweise wird das den Freizonen entsprechende Substratmaterial des ersten Trägersubstrats nach dem Durchtrennen des ersten Trägersubstrats aus dem Verbund herausgelöst. Folglich können in effizienter Weise Bereiche des zweiten Trägersubstrats, die unter den Freizonen liegen, freigelegt werden. Dadurch bleibt ferner abschnittsweise eine ebene Oberfläche des restlichen ersten Trägersubstrats erhalten und ermöglicht damit ein weiteres Verbinden bzw. Fügen mit einem weiteren Substrat.

Vorteilhafterweise sind von außen zu kontaktierende Bereiche des zweiten Trägersubstrats nach dem Schritt des Verbindens von einer Freizone überdeckt. Auf diese Weise können beispielsweise elektrische Kontaktanschlüsse effizient von außen zugänglich gemacht werden oder für die Kontaktierung für eine weitere anzubringende Substratschicht verwendet werden.

Gemäß einer bevorzugten Ausführungsform erfolgt das Bilden der Trenngräben durch Sägen. Der Einsatz dieser Standardtechnologie erlaubt ein effizientes und kostengünstiges Durchführen des erfindungsgemäßen Verfahrens.

In einer weiteren bevorzugten Ausführungsform erfolgt das Bilden der Trenngräben durch Ultraschallschleifen.

Vorteilhafterweise wird das Haftmittel mittels einer in der Ebene des ersten Trägersubstrats positionierbaren Dosiervorrichtung abgeschieden. Die Dosiervorrichtung gewährleistet ein genaues Aufbringen einer vorbestimmten Menge an Haftmittel, wodurch beim anschließenden Zusammenfügen reproduzierbar identische Klebestellen entstehen.

Geeigneterweise umfasst die Dosiervorrichtung eine programmierbare Steppervorrichtung. Dies ermöglicht es, auf einer großen Fügezone in genau bestimmten Abständen Haftmittel zu deponieren oder auf mehreren Fügezonen, Haftmittel in vorbestimmter Menge an jeweils gleichen Positionen zu deponieren.

In vorteilhafter Ausgestaltung wird die Oberfläche des ersten und/oder des zweiten Trägersubstrats im wesentlichen ganzflächig mit einem Haftmittel zur Verbindung der beiden Trägersubstrate bedeckt. Somit ist es in einfacher Weise möglich, das Haftmittel auf die Fügezonen des ersten Trägersubstrats aufzubringen, ohne einen präzisen Dosier- und Positionierschritt beim Abscheiden des Haftmittels zu benötigen.

Entsprechend einer vorteilhaften Ausgestaltung des erfindungsgemäßen Verfahrens sind das erste und/oder das zweite Trägersubstrat als Wafer ausgebildet. Das erfindungsgemäße Verfahren ist somit vorteilhafterweise auf kommerziell erhältliche, in vielen technischen Prozessen verwendeten Substratträger anwendbar.

Vorteilhaftenrveise ist das zweite Trägersubstrat ein in der Herstellung integrierter Halbleiterstrukturen verwendbarer Wafer. Auf diese Weise lassen sich herkömmlich erzeugte Halbleiterstrukturen durch zusätzliche Komponenten auf der Basis einer Gesamtwaferübertragung dieser Komponenten ergänzen.

Vorteilhafterweise ist das erste Trägersubstrat ein Glaswafer. Auf diese Weise lassen sich bevorzugt optische mikrofunktionale Elemente auf bzw. in einem mechanisch und thermisch stabilen Trägersubstrat realisieren.

In bevorzugter Ausgestaltung ist das Haftmittel ein Optikklebstoff. Dadurch lassen sich insbesondere optosensorische Elemente entsprechend dem erfindungsgemäßen Verfahren herstellen.

Gemäß einer bevorzugten Ausführungsform erfolgt das Justieren des ersten und zweiten Trägersubstrats optisch. Optische Justierverfahren sind in der Mikroelektronik wohlbekannt und ermöglichen somit ein Justieren unter Verwendung gängiger optischer Vorrichtungen.

Vorzugsweise erfolgt das Justieren des ersten und zweiten Trägersubstrats mittels Justiermarken auf dem zweiten Trägersubstrat durch optisches Justieren durch das erste Trägersubstrat hindurch. Mittels einer Justiermarke, die durch das transparente erste Trägersubstrat sichtbar ist, wird ein einfaches und effizientes Ausrichten der ersten und zweiten Trägersubstrate zueinander ermöglicht.

Im Anschluss wird die Erfindung anhand der angefügten Zeichnungen näher erläutert.

Es zeigen:
- Figuren 1a bis 1e:: schematisch einzelne Verfahrensschritte beim justierten Verbinden bzw. Fügen zweier Substrate entsprechend einer Ausführungsform der vorliegenden Erfindung;
- Figuren 2a bis 2f:: schematisch einzelne Verfahrensschritte beim justierten Fügen zweier Substrate gemäß einer weiteren Ausführungsform der vorliegenden Erfindung; und
- Figur 3:: ein Beispiel eines Trägersubstratverbundes, der durch eines der in Figur 1 oder 2 gezeigten Verfahren entsteht.

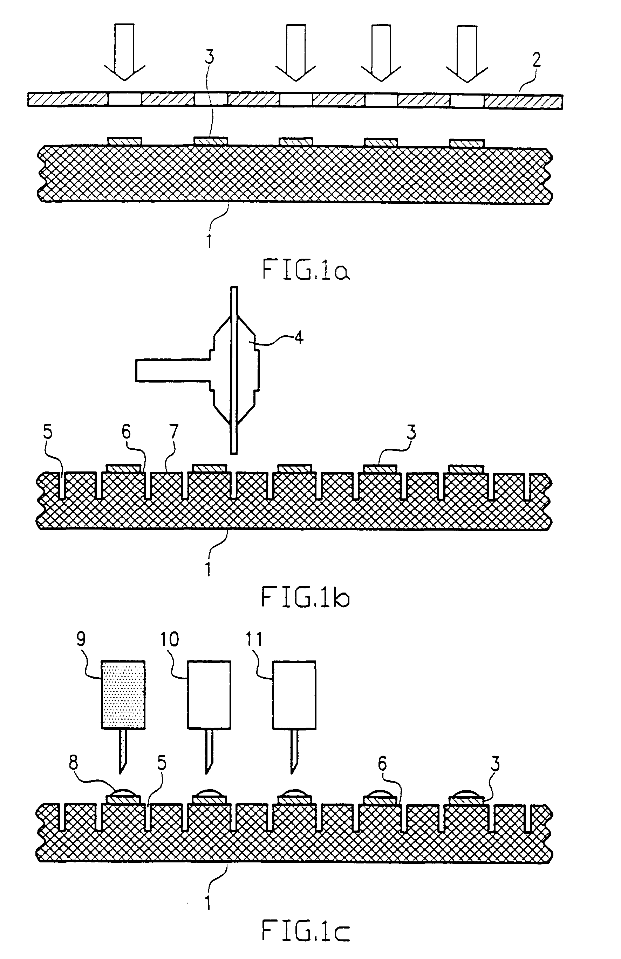

In den Figuren 1a bis 1e wird ein erstes Ausführungsbeispiel des erfindungsgemäßen Verfahrens schematisch dargestellt.

In Figur 1a ist ein erstes Trägersubtrat, das als ein Optikwafer 1 bezeichnet wird, gezeigt. Mittels einer Maske 2 wird auf der Oberfläche des Optikwafers 1 eine optische Struktur erzeugt, die in diesem Ausführungsbeispiel als Farbfilter 3 ausgebildet ist. Es soll jedoch betont werden, dass die auf dem Optikwafer 1 hergestellte optische Struktur nicht nur aus den Farbfiltern 3 bestehen kann, sondem diverse andere optische Komponenten, wie beispielsweise Prismen, Linsen, Gitter etc, umfassen kann. Ferner muss die Struktunerung des Optikwafers 1 nicht notwendigerweise auf der Oberfläche stattfinden, sondem die Strukturierung kann auch im Substratmaterial des Optikwafers 1, beispielsweise durch Änderung im Brechungsindex, ausgebildet sein.

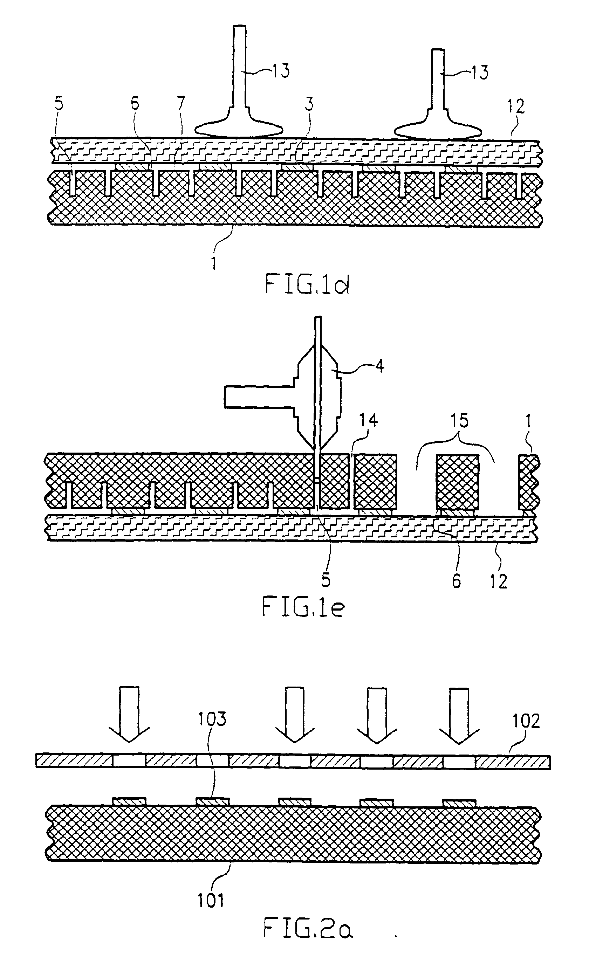

Figur 1 b zeigt schematisch einen auf das Ausbilden der Farbfilter 3 folgenden Verfahrensschritt. Im Optikwafer 1 werden mittels einer Chipsäge 4 werden Trenngräben 5 bis zu einer Tiefe von etwa 150 µm gebildet. Die Chipsäge kann beispielsweise die folgenden technischen Merkmale aufweisen: 22.000 Umdrehungen pro Minute, Durchmesser des Sägeblatts 5 cm, Dicke des kunstharzgebundenen Sägeblatts 300 µm mit einer Körnung von 40 µm. Die Trenngräben 5 separieren jeweils Fügezonen 6, die die optische Struktur, in diesem Fall die Farbfilter 3, tragen, und Freizonen 7. Die Trenngräben 5 werden dabei so gesetzt, dass die dabei entstehenden Fügezonen 6 und Freizonen 7 in ihren Abmessungen jeweils den fotosensitiven Bereichen eines in der Figur 1b nicht gezeigten Fotoempfängerwafers sowie den entsprechenden Anschlußkontakten entsprechen.

Figur 1c zeigt schematisch das Aufbringen eines Haftmittels auf die Fügezonen. Referenznummer 9 bezeichnet eine in der zur Zeichenebene in Figur 1c senkrecht stehenden Ebene positionierbare Dosiervorrichtung, die beispielsweise als eine Proberstation mit programmierbarem Stepper ausgebildet sein kann. Die Dosiervorrichtung 9 positioniert reproduzierbar eine geeignete Klebermenge 8 auf einer der optischen Strukturen 3 auf einer der Fügezonen 6. Die Referenzzeichen 10 und 11 bezeichnen die Dosiervorrichtung 9, jeweils in einem nächsten und übemächsten Schritt zum Abscheiden von Klebestoff.

Figur 1d zeigt schematisch den Schritt des justierten Fügens. Gemäß Figur 1d wird ein Fotoempfängerwafer 12, der in der Figur nicht gezeigte Justiermarken aufweist, mittels einer nicht gezeigten optischen Justiereinrichtung, die beispielsweise Justierlicht durch den transparenten Optikwafer 1 hindurch einstrahlt, so justiert, dass fotosensitive Bereiche des Fotoempfängerwafers 12 den Fügezonen 6 und Anschlusskontakte des Fotoempfängerwafers 12 den Freizonen 7 gegenüberliegen. Anschließend werden der Optikwafer 1 und der Fotoempfängerwafer 12 justiert zusammengefügt und mittels Stempel 13 mit leichtem Druck beaufschlagt. Dabei werden die in Figur 1d nicht gezeigten, dosiert aufgebrachten Klebermengen 8 über die einzelnen Fügezonen bis hin zu den Trenngräben 5 mit Kleber benetzt. Eventuell geringfügige überschüssige Klebermengen gelangen in die jeweiligen Trenngräben, aber nicht auf die Freizonen 7. Der Trenngraben 5 zwischen der Fügezone 6 und der Freizone 7 dient somit als Auffangbereich für überschüssigen Kleber.

Figur 1e zeigt schematisch einen weiteren Prozessschritt des erfindungsgemäßen Verfahrens. In Figur 1e wird nach dem Aushärten des Klebers 8 (in Figur 1e nicht gezeigt), der beispielsweise ein UV-härtender Optikklebstoff sein kann, der Trenngraben 5 von der Rückseite des Optikwafers 1 her mittels der Chipsäge 4 geöffnet, so dass der Optikwafer 1 an den Positionen der Trenngräben 5 vollständig durchtrennt ist. Dies ist durch Bezugszeichen 14 in der Zeichnung gekennzeichnet. Geeigneterweise wird beim Öffnen der Trenngräben 5 mittels der Chipsäge 4 das gleiche Sägeblatt wie beim Ausbilden der Trenngräben 5 verwendet. Durch den Strahldruck des Schnittwassers der Chipsäge werden gleichzeitig die mechanisch nicht fixierten Freizonen-Glaselemente herausgespült und die Anschlusskontakte des Fotoempfängerwafers 12 werden damit freigelegt. Die freigelegten Bereiche sind in der Figur 1e durch die Bezugszeichen 15 gekennzeichnet. Nachdem alle Kontaktanschlüsse freigelegt sind, kann entweder ein weiterer Waferaufbau erfolgen oder die somit gebildeten optoelektronischen Elemente werden durch Trennschnitte entlang der Bauelementgrenzen des Fotoempfängerwafers vereinzelt.

Die Figuren 2a bis 2f zeigen schematisch die Verfahrensschritte einer weiteren bevorzugten Ausführungsform des erfindungsgemäßen Verfahrens.

In Figur 2a ist ein Optikwafer 101 gezeigt, an dessen Oberfläche mittels einer Dampfschattenmaske 102 Farbfilter 103 gebildet werden.

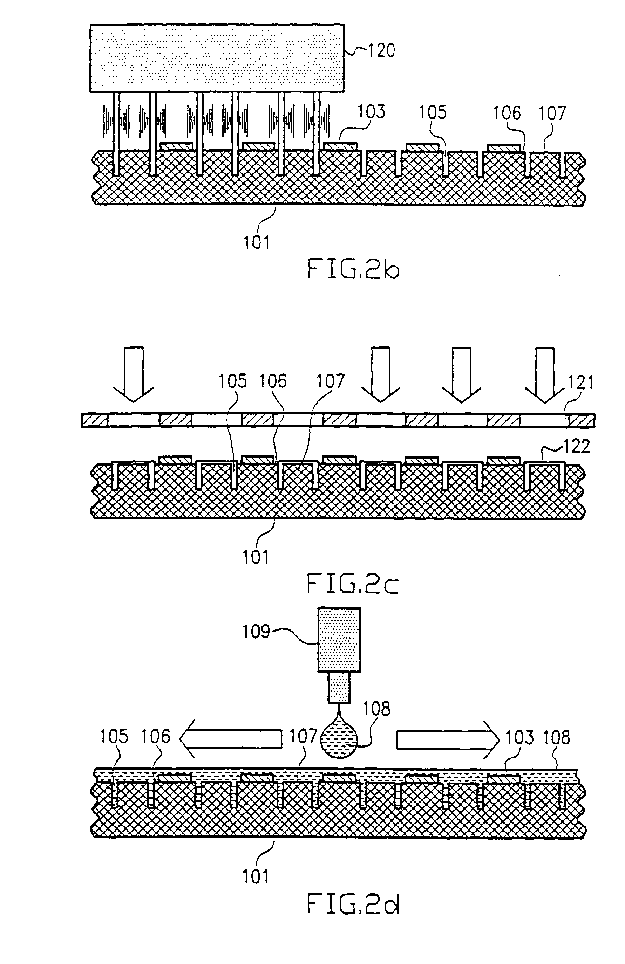

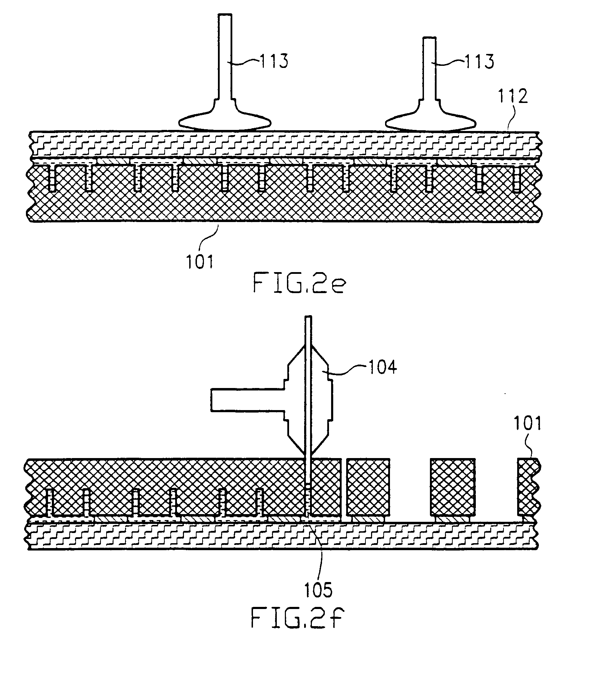

Figur 2b zeigt den Optikwafer 101, an dessen mit den Farbfiltern 103 strukturierten Obertläche Trenngräben 105 mittels eines Ultraschall-Werkzeugs 120 geformt werden.

Die Trenngräben 105 separieren Fügezonen 106, die die Farbfilter 103 beherbergen, und Freizonen 107.

Figur 2c zeigt schematisch das Aufbringen eines Trennmittels 122 auf die Freizonen 107 und auf die Trenngräben 105 mittels einer Maske 121.

In Figur 2d ist schematisch dargestellt, wie mittels einer Dosiervorrichtung 109 ein Optikklebstoff 108 ganzflächig über den Optikwafer 101 verteilt wird, wobei die Fügezonen 106 sowie die Freizonen 107 und die Trenngräben 105, die beide jeweils mit dem in Figur 2d nicht gezeigten Trennmittel 122 beschichtet sind, mit dem Optikklebstoff 108 bedeckt werden.

In Figur 2e ist schematisch gezeigt, wie ein Fotoempfängerwafer 112 mit dem Optikwafer 101 in Kontakt gebracht und mittels Stempel 113 mit Druck beaufschlagt wird, um die Wafer 101 und 112 miteinander zu verkleben. Bei dem Klebevorgang werden die Wafer 101 und 112 entsprechend der Vorgehensweise justiert, die zuvor mit Bezug zu Figur 1 d beschrieben wurde.

Figur 2f zeigt schematisch, wie mittels einer Chipsäge 104 die Trenngräben 105 von der Rückseite des Optikwafers 101 her geöffnet werden. Da durch das Trennmittel 122 eine Haftung der Glaselemente, die den Freizonen 107 entsprechen, verhindert wird, lösen sich die entsprechenden Glaselemente durch den Druck des Schnittwassers der Chipsäge 104 von dem Optikwafer 101.

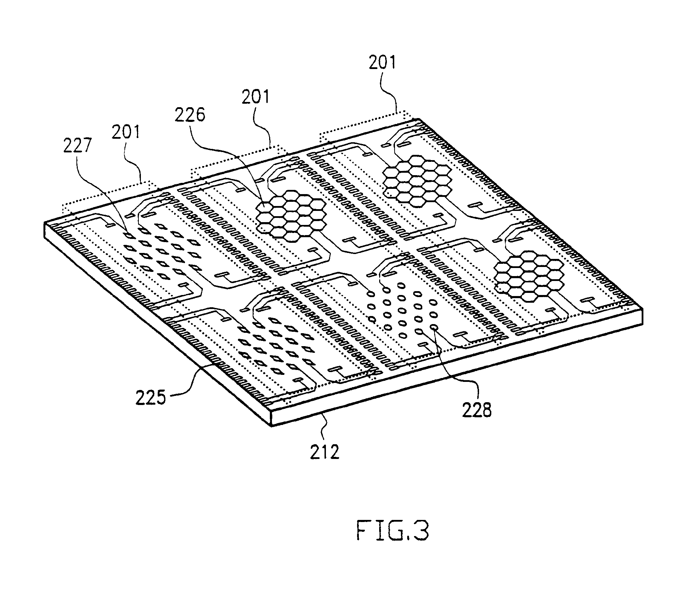

In Figur 3 ist eine schematische dreidimensionale perspektivische Ansicht eines Glas-Halbleiterverbundes dargestellt, wie er sich aus den beiden mit Bezug zu den Figuren 1 und 2 beschriebenen Ausführungsformen ergibt. Figur 3 zeigt einen Siliziumwafer 212 mit fotosensitiven Bereichen 226 und Kontaktanschlüssen 225. Auf der strukturierten Oberfläche des Siliziumwafers 212 sind Teile eines Glaswafers 201 aufgebracht, die als Beispiele für optische Elemente ein Farbfilterarray 227 und ein Linsenarray 228 aufweisen. Die Glaswaferbereiche, die die optischen Komponenten, wie beispielsweise das Farbfilterarray 227 und das Linsenarray 228, enthalten, entsprechen jeweils den Fügezonen 7 bzw. 107 in den Figuren 1 und 2. Die nicht mit Glas bedeckten Bereiche, die einen Zugang zu den Kontaktanschlüssen 225 des Siliziumwafers 212 erlauben, entsprechen den Freizonen 7 bzw. 107 in den Figuren 1 und 2.

Die vorliegende Erfindung wurde anhand zweier Ausführungsformen beschrieben, in denen jeweils Halbleiter- bzw. Glaswafer verwendet wurden. Das erfindungsgemäße Verfahren ist jedoch auch mit einer beliebigen anderen Kombination an Trägersubstraten verwendbar. Beispielsweise können zwei gleichartige Trägersubstrate, die verschiedenartige oder gleichartige funktionale Gruppen tragen, justiert gefügt werden. Die funktionalen Gruppen auf den jeweiligen Trägersubstraten können optischer, mechanischer, elektronischer, temperaturabhängiger oder einer beliebigen anderen sensorischen Art oder einer Kombination davon sein. Es ist auch möglich, Bauteilgruppen, die durchaus auf unterschiedlichen Substraten gefertigt sein können und deren Herstellung stark unterschiedliche Fertigungsverfahren erfordern kann, mit dem erfindungsgemäßen Verfahren zu einem Funktionsblock zusammenzufügen.

Insbesondere bei der Realisierung optoelektronischer Bauelemente bietet die vorliegende Erfindung Vorteile gegenüber konventionellen Verfahren. So kann in einfacher Weise die Kombination verschiedener Optikwafer, beispielsweise Wafer mit Farbfilterstrukturen unterschiedlicher spektraler Charakteristik mit Elektronikwafem des gleichen Typs bewerkstelligt werden, wodurch eine effektive Kleinstserienfertigung möglich ist. Femer braucht der Wafer vor der Integration optischer oder anderer Funktionen nicht mechanisch strukturiert sein. Somit sind die standardmäßigen Lithographieprozesse, wie beispielsweise die strukturierte Farbfilterbeschichtung bei der Präparierung von Optikwafern, bei der Herstellung von kombinierten Verbundbauteilen entsprechend dem erfindungsgemäßen Verfahren anwendbar.

## Patentansprüche

1. Verfahren zur Herstellung einer mikrofunktionalen Verbundvorrichtung mit zueinander justiert angebrachten mikrofunktionalen Elementen (3; 103),
wobei ein erster Teil der mikrofunktionalen Komponenten auf einem ersten Trägersubstrat (1; 101) geschaffen wird,
ein zweiter Teil der mikrofunktionalen Komponenten auf einem zweiten Trägersubstrat (12; 112) geschaffen wird, und
das erste und zweite Trägersubstrat zueinander justiert werden, und die zueinander justierten ersten und zweiten Trägersubstrate miteinander zur Bildung der mikrofunktionalen Verbundvonichtung verbunden werden,
wobei
das erste Trägersubstrat in Fügezonen (6; 106) und Freizonen (7; 107) durch Bildung von Trenngräben (5; 105) im ersten Trägersubstrat (1; 101) unterteilt wird, und die Verbindung des ersten und zweiten Trägersubstrats derart stattfindet, dass nur in den Fügezonen (6; 106) eine feste Verbindung der beiden Trägersubstrate erfolgt und die Freizonen (7; 107) des ersten Trägersubstrats aus der Verbundvorrichtung mechanisch herauslösbar sind,
**dadurch gekennzeichnet, dass**
auf den Freizonen und den Trenngräben des ersten Trägersubstrats oder diesen entsprechenden Bereichen des zweiten Trägersubstrats vor dem Verbinden der Trägersubstrate ein Trennmittel abgeschieden wird.

2. Das Verfahren nach Anspruch 1, **dadurch gekennzeichnet, dass** die Trenngräben des ersten Trägersubstrats vollständig geöffnet werden, wobei das erste Trägersubstrat durchtrennt wird.

3. Das Verfahren nach Anspruch 1 oder 2, **dadurch gekennzeichnet, dass** die feste Verbindung durch ein Haftmittel gebildet wird.

4. Das Verfahren nach Anspruch 2, **dadurch gekennzeichnet, dass** das der Freizone entsprechende Material des ersten Trägersubstrats nach dem Durchtrennen des ersten Trägersubstrats aus dem Verbund herausgelöst wird.

5. Das Verfahren nach einem der Ansprüche 1 bis 4, **dadurch gekennzeichnet, dass** von außen zu kontaktierende Bereiche des zweiten Trägersubstrats nach dem Schritt des Verbindens von einer Freizone überdeckt sind.

6. Das Verfahren nach einem der Ansprüche 1 bis 5, **dadurch gekennzeichnet, dass** das Bilden der Trenngräben durch Sägen erfolgt.

7. Das Verfahren nach einem der Ansprüche 1 bis 6, **dadurch gekennzeichnet, dass** das Bilden der Trenngräben durch Ultraschall-Schleifen erfolgt.

8. Das Verfahren nach Anspruch 3, **dadurch gekennzeichnet, dass** das Haftmittel mittels einer in der Ebene des ersten Trägersubstrats positionierbaren Dosiervorrichtung im Bereich der Fügezonen abgeschieden wird.

9. Das Verfahren nach Anspruch 8, **dadurch gekennzeichnet, dass** die Dosiervorrichtung eine programmierbare Stepper-Vorrichtung umfasst.

10. Das Verfahren nach Anspruch 1, **dadurch gekennzeichnet, dass** die Oberfläche des ersten und/oder zweiten Trägersubstrats im wesentlichen ganzflächig mit einem Haftmittel zur Verbindung der beiden Trägersubstrate bedeckt wird.

11. Das Verfahren nach einem der Ansprüche 1 bis 10, **dadurch gekennzeichnet, dass** das erste und/oder das zweite Trägersubstrat als Wafer ausgebildet sind.

12. Das Verfahren nach Anspruch 11, **dadurch gekennzeichnet, dass** das zweite Trägersubstrat ein in der Herstellung integrierter Halbleiterstrukturen verwendbarer Wafer ist.

13. Das Verfahren nach Anspruch 11 oder 12, **dadurch gekennzeichnet, dass** das erste Trägersubstrat ein Glaswafer ist.

14. Das Verfahren nach Anspruch 3 oder 10, **dadurch gekennzeichnet, dass** das Haftmittel ein Optikklebstoff ist.

15. Das Verfahren nach einem der Ansprüche 1 bis 14, **dadurch gekennzeichnet, dass** das Justieren des ersten und zweiten Trägersubstrats optisch erfolgt.

16. Das Verfahren nach Anspruch 13, **dadurch gekennzeichnet, dass** das Justieren des ersten und zweiten Trägersubstrats mittels Justiermarken auf dem ersten und zweiten Trägersubstrat durch optisches Justieren durch das erste Trägersubstrat hindurch erfolgt.

## Claims

1. Method for the production of a microfunctional composite device having microfunctional elements (3; 103) applied mutually aligned,
wherein a first part of the microfunctional components is formed on a first support substrate (1; 101),
a second part of the microfunctional components is formed on a second support substrate (12; 112), and the first and second support substrates are mutually aligned, and the mutually aligned first and second support substrates are connected together to form a microfunctional composite device,
wherein
the first support substrate is subdivided into junction zones (6; 106) and free zones (7; 107) by the formation of separating trenches (5; 105) in the first support substrate (1; 101), and the connection of the first and second support substrates is carried out so that a firm connection of the two support substrates is made only in the junction zones (6; 106) and the free zones (7; 107) of the first support substrate can be mechanically detached from the composite device,
**characterised in that**
a separating medium is deposited on the free zones and the separating trenches of the first support substrate, or regions corresponding thereto of the second support substrate, before the connection of the support substrates.

2. Method according to Claim 1, **characterised in that** the separating trenches of the first support substrate are fully open, the first support substrate being cut through.

3. Method according to Claim 1 or 2, **characterised in that** the firm connection is formed by a bonding medium.

4. Method according to Claim 2, **characterised in that** material of the first support substrate corresponding to the free zone is detached from the composite after cutting through the first support substrate.

5. Method according one of Claims 1 to 4, **characterised in that** regions of the second support substrate to be contacted from the outside are covered by a free zone after the connection step.

6. Method according to one of Claims 1 to 5, **characterised in that** the separating trenches are formed by sawing.

7. Method according to one of Claims 1 to 6, **characterised in that** the separating trenches are formed by ultrasonic grinding.

8. Method according to Claim 3, **characterised in that** the bonding medium is deposited in the region of the junction zones by a dosing device which can be positioned in the plane of the first support substrate.

9. Method according to Claim 8, **characterised in that** the dosing device comprises a programmable stepper device.

10. Method according to Claim 1, **characterised in that** the surface of the first and/or second support substrate is covered substantially surface-wide with a bonding medium for connecting the two support substrates.

11. Method according to one of Claims 1 to 10, **characterised in that** the first and/or second support substrate is designed as a wafer.

12. Method according to Claim 11, **characterised in that** the second support substrate is a wafer which can be used in the production of integrated semiconductor structures.

13. Method according to Claim 11 or 12, **characterised in that** the first support substrate is a glass wafer.

14. Method according to Claim 3 or 10, **characterised in that** the bonding medium is an optical adhesive.

15. Method according to one of Claims 1 to 14, **characterised in that** the alignment of the first and second support substrates is carried out optically.

16. Method according to Claim 13, **characterised in that** the alignment of the first and second support substrates is carried out by means of alignment marks on the first and second support substrates by optical alignment through the first support substrate.

## Revendications

1. Procédé de fabrication d'un dispositif composite microfonctionnel avec des éléments microfonctionnels (3 ; 103) montés l'un à l'autre de façon ajustée,
une première partie des composants microfonctionnels étant montée sur un premier substrat porteur (1 ; 101),
une deuxième partie des composants microfonctionnels étant montée sur un deuxième substrat porteur (12 ; 112), et
le premier et le deuxième substrat porteurs étant réciproquement ajustés et les premier et deuxième substrats porteurs réciproquement ajustés étant reliés l'un à l'autre pour créer le dispositif composite microfonctionnel,
le premier substrat porteur étant divisé en zones de joint (6 ; 106) et zones libres (7 ; 107) par création de tranchées de séparation (5 ; 105) dans le premier substrat porteur (1 ; 101) et la liaison entre les premier et deuxième substrats porteurs étant assurée par liaison fixe entre les deux substrats porteurs uniquement dans la zone de joint (6 ; 106), alors que les zones libres (7 ; 107) du premier substrat porteur peuvent être mécaniquement extraites du dispositif composite,
**caractérisé en ce qu'**avant la liaison des substrats porteurs, un agent séparateur est déposé sur les zones libres et sur les tranchées de séparation du premier substrat porteur ou sur des régions leur correspondant sur le deuxième substrat porteur.

2. Procédé selon la revendication 1, **caractérisé en ce qu'**on ouvre complètement les tranchées de séparation du premier substrat porteur, le premier substrat porteur étant ainsi sectionné.

3. Procédé selon la revendication 1 ou 2, **caractérisé en ce que** le liaison fixe est créée par un agent adhésif.

4. Procédé selon la revendication 2, **caractérisé en ce qu'**après le sectionnement du premier substrat porteur, on extrait du composite le matériau correspondant à la zone libre du premier substrat porteur.

5. Procédé selon l'une des revendications 1 à 4, **caractérisé en ce qu'**après l'étape de liaison, des régions du deuxième substrat porteur qui doivent être mises en contact par l'extérieur sont recouvertes d'une zone libre.

6. Procédé selon l'une des revendications 1 à 5, **caractérisé en ce qu'**on crée les tranchées de séparation par sciage.

7. Procédé selon l'une des revendications 1 à 6, **caractérisé en ce qu'**on crée les tranchées de séparation par meulage aux ultrasons.

8. Procédé selon la revendication 3, **caractérisé en ce qu'**on dépose l'agent adhésif dans la région des zones de joint au moyen d'un dispositif de dosage positionnable dans le plan du premier substrat porteur.

9. Procédé selon la revendication 8, **caractérisé en ce que** le dispositif de dosage comprend un dispositif de piquage programmable.

10. Procédé selon la revendication 1, **caractérisé en ce qu'**on recouvre la surface du premier et/ou du deuxième substrat porteurs sensiblement à pleine surface d'un agent adhésif pour la liaison des deux substrats porteurs.

11. Procédé selon l'une des revendications 1 à 10, **caractérisé en ce que** le premier et/ou le deuxième substrat porteurs sont conçus sous forme d'une tranche de silicium.

12. Procédé selon la revendication 11, **caractérisé en ce que** le deuxième substrat porteur est une tranche de silicium utilisable lors de la fabrication de structures de semi-conducteurs intégrés.

13. Procédé selon la revendication 11 ou 12, **caractérisé en ce que** le premier substrat porteur est une tranche de verre.

14. Procédé selon la revendication 3 ou 10, **caractérisé en ce que** l'agent adhésif est une colle optique.

15. Procédé selon l'une des revendications 1 à 14, **caractérisé en ce que** l'ajustage du premier et du deuxième substrat porteurs est assuré par moyen optique.

16. Procédé selon la revendication 13, **caractérisé en ce que** l'ajustage du premier et du deuxième substrat porteur est assuré au moyen de marques d'ajustage sur le premier et le deuxième substrat, par ajustage optique à travers le premier substrat porteur.
